# EUROPEAN PATENT APPLICATION

(11) **EP 4 606 548 A1**
(43) Date of publication of application: **27.08.2025**
(21) Application number: 25157885.2
(22) Date of filing: 14.02.2025
(51) Int. Cl.: B29C 45/16, D06F 39/12, F25D 23/12, B29L 31/00, B29C 45/00, B29K 105/26

(54) **COMPONENT FOR HOME APPLIANCE**

(30) Priority: 26.02.2024 KR 20240027431
(71) Applicant: LG Electronics Inc., Yeongdeungpo-gu Seoul 07336 (KR)
(72) Inventor: YOU, Youngdae, 08592 Seoul (KR); LIM, Hyunsu, 08592 Seoul (KR); KIM, Sunwoo, 08592 Seoul (KR); JEONG, Seokjae, 08592 Seoul (KR)
(74) Representative: Vossius & Partner Patentanwälte Rechtsanwälte mbB

(57) **Abstract**

A component for a home appliance of the present disclosure is formed so that at least a first portion (210) of the component has both a skin layer (211) made of a first material and a core layer (212) made of a second material, and at least a second portion (220) of the component has only a core layer (222) made of a third material, thereby reducing manufacturing costs. The second portion (220) may be defined as a portion that is not visible to a user.

## Description

### CROSS REFERENCE TO RELATED APPLICATION

The present application claims priority to Korean Patent Application No. 10-2024-0027431, filed February 26, 2024, the entire contents of which are incorporated herein for all purposes by this reference.

### BACKGROUND OF THE INVENTION

### Field of the Invention

The present disclosure relates to a new type of component for a home appliance in which different materials are allowed to be used for an exposed portion visible to a user and an unexposed portion invisible to the user.

### Description of the Related Art

Generally, home appliances are electrical appliances that are provided in a home and use energy such as electricity or heat.

These home appliances include a variety of products such as washing machines, storage devices, thermostats, and air purifiers.

The exterior of each component of the home appliances may be formed with various materials or colors. For example, in order to achieve the sophistication of home appliances, the exterior of certain parts is made of metal or is made of materials and colors that give a metallic texture. For example, the exterior of a part is formed by using metallic materials that are lighter than metal materials but still have metallic textures.

However, the aforementioned metallic materials are relatively expensive, and thus, when the entire exterior of a part is molded with the metallic materials, the overall manufacturing cost is unavoidably expensive.

Accordingly, various studies are being conducted recently to lower manufacturing costs while achieving the sophistication of the appearance of parts.

Korean Patent Application Publication No. 10-2023-0131731 provides a technology that allows the outer surface and the inner portion of the exterior of a component for a home appliance to be made of different materials, and when this technology is used, the manufacturing cost of the exterior can be reduced. That is, a skin layer constituting the outer surface is formed of metallic resin, and a core layer constituting the inner portion is formed of recycled resin, thereby reducing the manufacturing cost.

However, in the case of the component for a home appliance according to the above-described conventional technology, since it is an injection molding method that injects two different materials of resin by using one valve, the position of a gate through which an injection material is injected is limited and is unavoidably minimized. Accordingly, it is difficult to apply the method to a large part (e.g., a casing of a home appliance).

In addition, in the component for a home appliance according to the above-described conventional technology, the position of the gate through which an injection material is injected is limited, and thus injection defects occur in portions (e.g., edges or corners) located relatively far from the injection gate.

In addition, in the component for a home appliance according to the above-described conventional technology, the process of injecting the core layer into the skin layer must proceed slowly to prevent defects, and thus the overall manufacturing time is unavoidably long.

### Document of Related Art

(Patent Document 1) Korean Patent Application Publication No. 10-2023-0131731

### SUMMARY OF THE INVENTION

Accordingly, the present disclosure has been made keeping in mind the above problems occurring in the related art, and the present disclosure is intended to provide a new type of component for a home appliance that allows material costs to be reduced during molding for an exterior thereof.

In addition, the present disclosure is intended to provide a new type of component for a home appliance that allows injection molding for large parts to be smoothly performed.

In addition, the present disclosure is intended to provide a new type of component for a home appliance that allows a core layer to be prevented from being exposed to a portion that is visible to the naked eye.

In addition, the present disclosure is intended to provide a new type of component for a home appliance that allows injection molding to proceed quickly so as to decrease manufacturing time for manufacturing parts.

In order to achieve the objectives of the present disclosure, according to a component for a home appliance of the present disclosure, at least a portion of the component may be formed to have both a skin layer and a core layer, and at least a portion of the component may be formed to have only a core layer. Accordingly, manufacturing costs may be reduced.

According to the component for a home appliance of the present disclosure, at least a portion of the component may be formed to have both a first material and a second material, and at least a portion of the component may be formed to have a third material. Accordingly, each of the portions may be formed of a different material depending on a characteristic of the corresponding portion.

The component for a home appliance of the present disclosure may include a first portion which includes the skin layer constituting an outer surface thereof and injection-molded with the first material, and the core layer located inside the skin layer and injection-molded with the second material.

The component for a home appliance of the present disclosure may include a second portion injection-molded with the third material.

According to the component for a home appliance of the present disclosure, the first portion and the second portion may be integrally formed.

According to the component for a home appliance of the present disclosure, the first portion may include a portion of the corresponding home appliance that is visible to a user.

According to the component for a home appliance of the present disclosure, the second portion may include a portion of the corresponding home appliance that is not visible to a user.

According to the component for a home appliance of the present disclosure, the second portion may include a portion that is covered by another component for the home appliance.

According to the component for a home appliance of the present disclosure, the first portion and the second portion may be provided in different colors.

According to the component for a home appliance of the present disclosure, the first portion and the second portion may be provided in the same color.

According to the component for a home appliance of the present disclosure, the first portion and the second portion may be provided with injection gates, respectively, through which each of the materials is supplied.

According to the component for a home appliance of the present disclosure, the first portion may be provided with a first injection gate through which the first material and the second material are sequentially injected.

According to the component for a home appliance of the present disclosure, the first injection gate may include one first injection gate or at least two first injection gates.

According to the component for a home appliance of the present disclosure, the second portion may be provided with a second injection gate through which the third material is injected.

According to the component for a home appliance of the present disclosure, the second injection gate may include one second injection gate or at least two second injection gates.

According to the component for a home appliance of the present disclosure, a boundary between the first portion and the second portion may be formed so that the first portion and the second portion are connected to each other in a vertical direction of a corresponding home appliance.

According to the component for a home appliance of the present disclosure, a boundary between the first portion and the second portion may be formed so that the first portion and the second portion are connected to each other in a horizontal direction of a corresponding home appliance.

According to the component for a home appliance of the present disclosure, a boundary between the first portion and the second portion may be formed so that a thickness of the skin layer constituting the first portion gradually decreases toward the second portion.

According to the component for a home appliance of the present disclosure, a boundary between the first portion and the second portion may be formed so that a thickness of the core layer constituting the first portion gradually increases toward the second portion.

According to the component for a home appliance of the present disclosure, the second material and the third material may be formed of the same materials.

According to the component for a home appliance of the present disclosure, the second material and the third material may be formed of different materials.

According to the component for a home appliance of the present disclosure, the second material may include the third material.

According to the component for a home appliance of the present disclosure, the third material may include the second material.

As described above, the component for a home appliance of the present disclosure has the following various effects.

In the component for a home appliance of the present disclosure, the amount of second material or third material that is relatively cheaper than the first material is increased, thereby reducing the overall manufacturing cost.

In addition, in the component for a home appliance of the present disclosure, the first portion and the second portion are molded by using the different injection gates, and thus injection molding is capable of proceeding quickly, thereby decreasing manufacturing time.

In addition, in the component for a home appliance of the present disclosure, the first portion and the second portion are molded by using the different injection gates, thereby enabling injection molding of large parts to proceed smoothly.

In addition, in the component for a home appliance of the present disclosure, a portion that is visible to the naked eye, is formed with the skin layer and the core layer, and a portion that is not visible to the naked eye is formed with only the core layer, thereby reducing a manufacturing cost while achieving a more sophisticated design.

### BRIEF DESCRIPTION OF THE DRAWINGS

The above and other objectives, features, and other advantages of the present disclosure will be more clearly understood from the following detailed description when taken in conjunction with the accompanying drawings, in which:
FIG. 1 is a perspective view of an application state of a component for a home appliance of the present disclosure when the component is a dispenser panel provided on a door of a refrigerator;
FIG. 2 is a front view of the application state of the component for a home appliance of the present disclosure when the component is the dispenser panel provided on the door of a refrigerator;
FIG. 3 is a perspective view of the component for a home appliance of the present disclosure when it is the dispenser panel provided on the door of a refrigerator;
FIG. 4 is a front view of the component for a home appliance of the present disclosure when the component is the dispenser panel provided on the door of a refrigerator;
FIG. 5 is a rear view of the component for a home appliance of the present disclosure when the component is the dispenser panel provided on the door of a refrigerator;
FIG. 6 is a side view of the component for a home appliance of the present disclosure when the component is the dispenser panel provided on the door of a refrigerator;
FIG. 7 is a plan view of the component for a home appliance of the present disclosure when the component is the dispenser panel provided on the door of a refrigerator;
FIG. 8 is a cross-sectional view of the component for a home appliance of the present disclosure when the component is the dispenser panel provided on the door of a refrigerator;
FIG. 9 is an enlarged view of part "A" of FIG. 8;
FIG. 10 is an enlarged view of part "B" of FIG. 8;
FIG. 11 is an enlarged cross-sectional view of an example of the component for a home appliance of the present disclosure;
FIG. 12 is a state diagram of an example of a molding device for forming the component for a home appliance of the present disclosure;
FIG. 13 is a state diagram of a relationship between a control device and each valve in the molding device that molds the component for a home appliance of the present disclosure;
FIGS. 14 to 18 are enlarged cross-sectional views for each embodiment to explain a relationship between a first portion and a second portion in the component for a home appliance of the present disclosure;
FIG. 19 is a perspective view of the sixth form of the component for a home appliance of the present disclosure;
FIG. 20 is a rear view of the sixth form of the component for a home appliance of the present disclosure;
FIG. 21 is a plan view of the sixth form of the component for a home appliance of the present disclosure; and
FIGS. 22 to 25 are state views showing respective embodiments of the arrangement state for each injection gate of the component for a home appliance of the present disclosure.

### DETAILED DESCRIPTION OF THE INVENTION

Embodiments of the present disclosure are described through illustrative drawings. When adding reference numerals to components in each drawing, it should be noted that identical components are given the same reference numerals as much as possible even if they are shown in different drawings.

Additionally, when explaining an example of the present disclosure, if a detailed description of the related known structure or function is determined to impede understanding of the embodiments of the present disclosure, the detailed description thereof is omitted.

In addition, in describing the components of the embodiment of the present disclosure, terms such as first, second, A, B, (a), and (b) may be used. These terms are only for distinguishing the components from other components, and the nature or order of the components is not limited by the terms. When a component is described as being "connected" or "coupled" to another component, the component may be directly connected to or coupled to the another component, but it should be understood that still another component may be "connected" or "coupled" thereto between each component.

Hereinafter, preferred embodiments of a component for a home appliance of the present disclosure are described with reference to the attached drawings 1 to 25.

Before describing the embodiments, in the component for a home appliance of the present disclosure, the home appliance may be defined as an electronic product used in a home. For example, the home appliance may be any one of a variety of products, such as a washing machine, a refrigerator, a dishwasher, a water purifier, a clothing care system, an air purifier, an air conditioner, an oven, a dryer, and a TV.

In addition, in the component for a home appliance of the present disclosure, the component may be defined as a device or accessory used in a home appliance, or at least one part of a device or accessory. For example, the component may be a component or portion of an exterior portion of a home appliance that may be manufactured by injection molding.

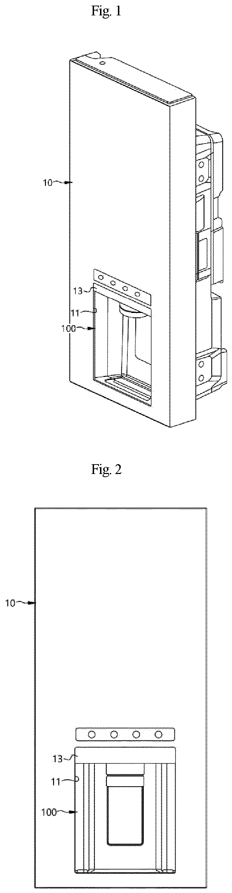

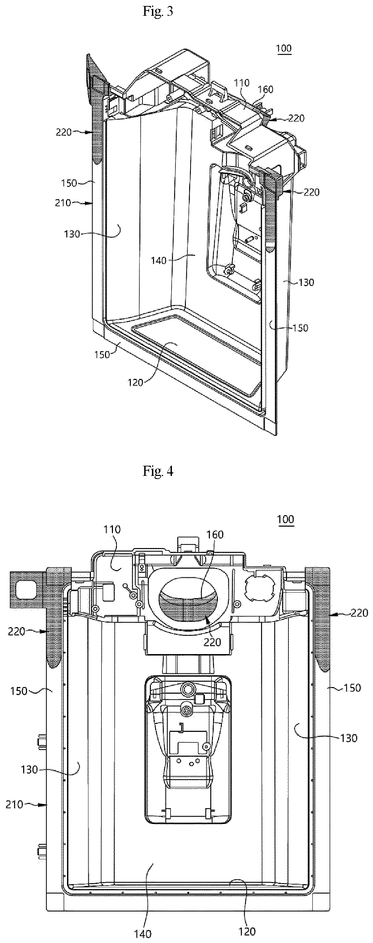

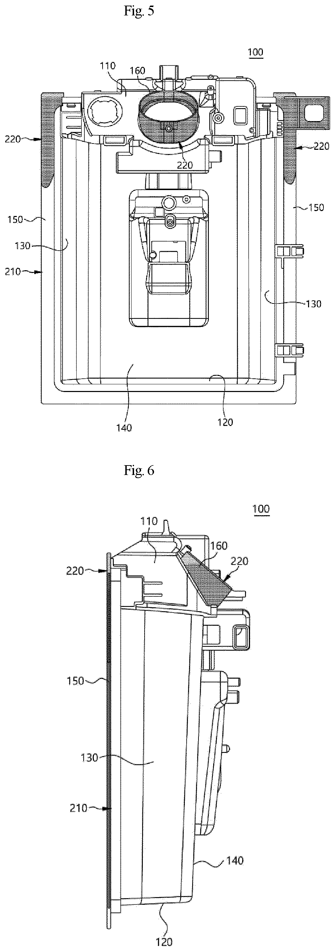

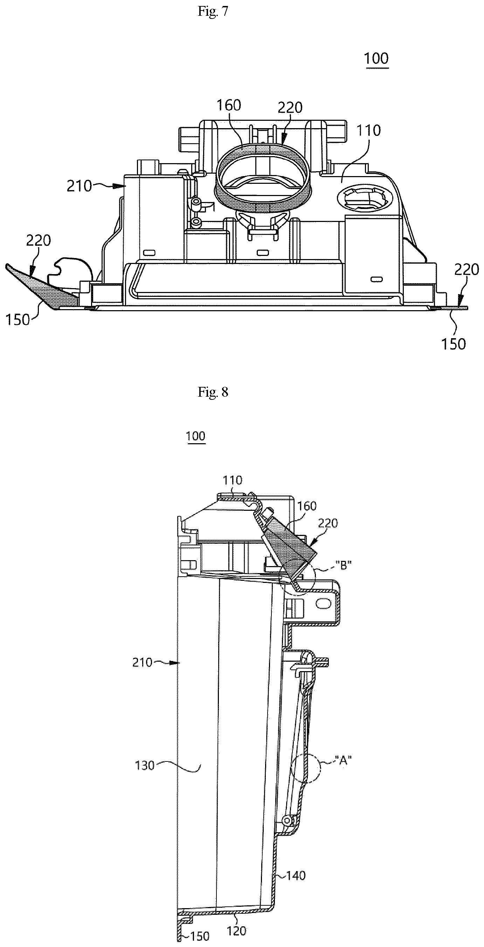

FIGS. 1 and 2 are views illustrating states of an installation form when the component for a home appliance of the present disclosure is a dispenser panel provided on a refrigerator door, and FIGS 3 to 10 are views illustrating states in which a first portion and a second portion are applied in the dispenser panel.

Here, the component for a home appliance in the embodiment of the present disclosure is, for example, a dispenser panel 100 used in a refrigerator. In this case, the dispenser panel 100 is detachably installed on a refrigerator door 10 and forms each wall of a space in which ice or beverages are dispensed and a cup is placed.

A brief description of the dispenser panel 100 is as follows.

The dispenser panel 100 may include perimeter walls 110, 120, and 130, and a rear wall 140. That is, the dispenser panel 100 may be formed as a box-shaped body with an open front. The perimeter walls 110, 120, and 130 of the dispenser panel 100 may include an upper wall 110, a lower wall 120, and two side walls 130.

Outwardly bent edge parts 150 may be formed on the front ends of the two side walls 130 and the lower wall 120 of the dispenser panel 100. That is, the edge parts 150 may be provided on the ends of the two side walls 130 and the lower wall 120, respectively.

Each of the edge parts 150 may be provided as a part that is received and coupled to the inside of the outer wall of the refrigerator door 10. That is, a cut opening 11 may be formed in the outer wall of the refrigerator door 10 to provide a dispensing space, and the dispenser panel 100 may be inserted into and mounted within the cut opening 11 of the refrigerator door 10, thereby providing the perimeter walls 110, 120, and 130, and the rear wall 140 of the dispensing space. In this case, each of the edge parts 150 of the dispenser panel 100 may be positioned around the cut opening 11 of the inner surface of the outer wall of the refrigerator door 10 to prevent the dispenser panel 100 from being removed forward.

An exit pipe 160 may be formed on the upper wall of the dispenser panel 100. Although not shown, a nozzle or pipe for dispensing beverages or ice may be connected to the exit pipe 160.

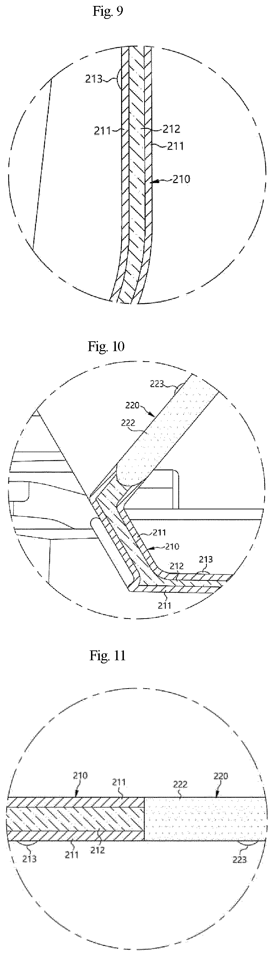

Next, the features of the component for a home appliance according to the embodiment of the present disclosure will be described with reference to FIGS. 11 to 15.

The component for a home appliance according to the embodiment of the present disclosure may be formed so that at least a portion of the component has both a skin layer 211 and a core layer 212, and at least a portion of the component has only a core layer 222.

More specifically, in the component for a home appliance according to the embodiment of the present disclosure, at least a portion thereof may be made of a first material and a second material, and at least a portion thereof may be made of a third material different from the first material.

This structure is designed to reduce the overall manufacturing cost of the corresponding component for a home appliance. In addition, due to the structure, the corresponding component for a home appliance may have more improved characteristics.

This is described in more detail as follows.

First, the component for a home appliance of the embodiment of the present disclosure may include a first portion 210 provided with both the skin layer 211 and the core layer 212 as illustrated in FIG. 11.

The first portion 210 may include a portion of a corresponding home appliance that is visible to a user. That is, the first portion 210 may be defined as a portion that is visible to a user with the naked eye.

For example, as illustrated in FIGS. 3 to 10, on the basis of the dispenser panel 100 of the refrigerator, the first portion 210 may include the rear wall 140, the two side walls 130, and the lower wall 120.

The skin layer 211 constituting the first portion 210 may constitute the outer surface of the component for a home appliance and be injection-molded with the first material. For example, the skin layer 211 may be defined as the outer surface of the dispenser panel 100.

The first material provided as the skin layer 211 may be, for example, a metallic material. That is, the skin layer 211 may be formed with a metallic material so that the sophistication of the exterior is achieved.

The core layer 212 constituting the first portion 210 may be positioned within the skin layer 211 and be injection-molded with the second material. That is, the core layer 212, which is a portion surrounded by the skin layers 211, may be defined as the interior of the component for a home appliance.

The second material provided as the core layer 212 may be, for example, a recycled resin. That is, the core layer 212 may be formed of a recycled resin that is less expensive than the skin layer 211, thereby reducing the manufacturing cost.

The core layer 212 may be formed to be completely surrounded by the skin layer 211. That is, when the first portion 210 is viewed in cross-section, the core layer 212 is formed to be positioned between two skin layers 211.

Accordingly, since the portion that a user can see with the naked eye are provided as the skin layer 211 molded with the first material, the sophistication of the product may be achieved, and since the core layer 212 molded with the second material is provided inside the skin layer 211, the manufacturing cost may be reduced.

Meanwhile, the first portion 210 may be formed through a dual injection process. For example, the first portion 210 may be formed in a molding device 20 capable of injecting and molding each of the first material and the second material.

The first material and the second material may be sequentially injected to form the first portion 210. Accordingly, a first injection gate 213 through which the first material and the second material are sequentially injected may be provided on the first portion 210. The first injection gate 213 may remain as a trace on the first portion 210 after molding the component for a home appliance.

The first injection gate 213 may include one first injection gate or two or more first injection gates depending on the size or shape (structure) of the component for a home appliance.

That is, when the size of the component for a home appliance to be manufactured is small, the first injection gate 213 may include one first injection gate. On the other hand, when the component for a home appliance to be manufactured is large in size or has a complex structure, the first injection gate 213 may include at least two first injection gates.

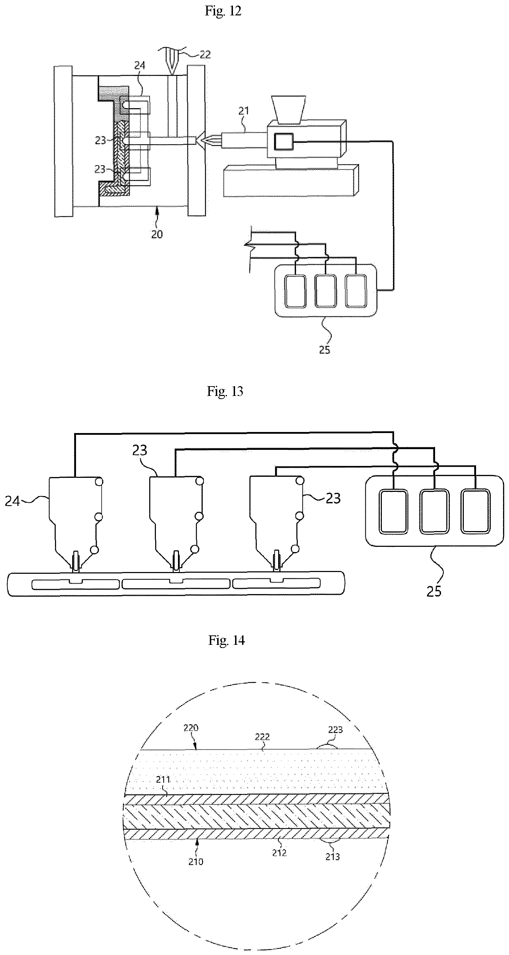

As shown in FIGS. 12 and 13, a nozzle for supplying resin to the molding device 20 may include a first nozzle 21 for supplying the first material and a second nozzle 22 for supplying the second material.

When the first injection gate 213 includes the plurality of first injection gates, the molding device 20 may be provided with a plurality of valves 23 for selectively injecting resin supplied from each of the nozzles 21 and 22 into each of the first injection gates 213. In this case, the operation of each of the valves 23 may be controlled by a control device 25 capable of sequence control.

Next, the component for a home appliance of the embodiment of the present disclosure may include a second portion 220 consisting of the core layer 222.

The second portion 220 may include a portion of the appliance that is not visible to a user. That is, the second portion 220 may be defined as a portion that is not visible to a user with the naked eye or is not easily recognizable unless observed closely.

For example, when viewed on the basis of the dispenser panel 100 of the refrigerator, the second portion 220 may include the upper wall 110 or the edge parts 150 as shown in FIGS. 3 to 10.

Preferably, a corner portion of the upper wall 110, a portion of the edge parts 150 located on the upper side of the dispenser panel 100, or the exit pipe 160 formed on the upper wall 110 may be formed as the second portion 220.

Meanwhile, the second portion 220 may include a portion that is covered by another component for a home appliance. That is, since a portion covered by other components for a home appliance is also a portion that is not visible to a user with the naked eye, the portion may be provided as the second portion 220 of the component for a home appliance according to the embodiment of the present disclosure.

For example, in the case of a structure in which a dispenser part is provided on the refrigerator door 10, a cover body 13 may be provided on the upper end of the dispenser panel 100. In this case, a portion covered by the cover body 13 may be provided as the second portion 220.

The second portion 220 may be injection-molded with the third material. Here, the third material may be provided as the same material as the second material forming the core layer 212 of the first portion 210. For example, the third material may be a recycled resin.

That is, by forming an unexposed portion, which is virtually imperceptible to a user, only with inexpensive recycled resin, the manufacturing cost may be further reduced compared to the first portion 210 in which the first material and the second material are mixed.

The second portion 220 may be formed through injection molding. For example, the second portion 220 may be molded in the molding device 20 capable of injecting the third material.

To this end, a second injection gate 223 for injecting the third material may be provided in the second portion 220. The second injection gate 223 may be provided separately from the first injection gate 213 of the first portion 210, and may include one second injection gate or two or more second injection gates.

Accordingly, the component for a home appliance of the embodiment of the present disclosure may include the at least one first injection gate 213 and the at least one second injection gate 223 provided simultaneously.

The molding device 20 may be provided with a second valve 24 to inject resin into the second injection gate 223. The second valve 24 is a valve that operates to selectively inject resin supplied from each of the nozzles 21 and 22 into the second injection gate 223. The operation of the second valve 24 may be controlled by the control device 25.

The second portion 220 and the first portion 210 may be integrally formed through dual injection. For example, the first portion 210 may be injection-molded first and then the second portion 220 may be injection-molded, or the second portion 220 may be injection-molded first and then the first portion 210 may be injection-molded.

Meanwhile, a boundary between the first portion 210 and the second portion 220 may be formed so that the first portion 210 and the second portion 220 are connected to each other in the horizontal direction of the home appliance as shown in FIG. 11, but the boundary between the first portion 210 and the second portion 220 may be formed so that the first portion 210 and the second portion 220 are connected to each other in the vertical direction of the home appliance as shown in FIG. 14. That is, the first portion 210 and the second portion 220 are formed by injecting each of the materials in opposite directions so that the materials meet each other and are integral.

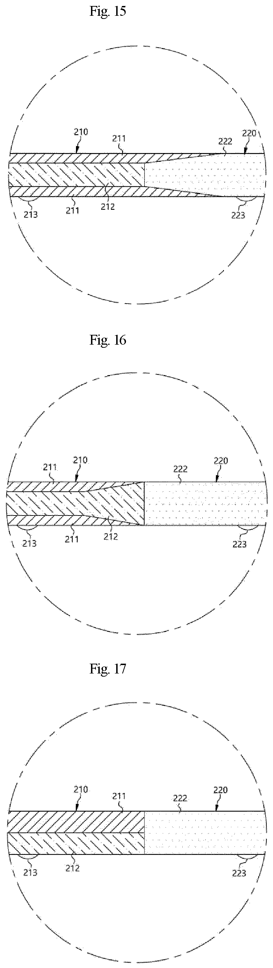

In particular, the boundary between the first portion 210 and the second portion 220 may be formed so that the thickness of the skin layer 211 constituting the first portion 210 gradually decreases toward the second portion 220. That is, as illustrated in FIG. 15, the thickness of the skin layer 211 may gradually decrease toward the non-exposed portion of the component for a home appliance, thereby further increasing the mixing ratio of the third material of the second portion 220. Accordingly, the overall manufacturing cost may be reduced.

Of course, the boundary between the first portion 210 and the second portion 220 may be formed so that the thickness of the core layer 212 constituting the first portion 210 gradually decreases toward the second portion 220, as illustrated in FIG. 16. The structure is designed such that the amount of the core layer 212 of the first portion 210 gradually increases toward the second portion 220. Accordingly, the overall manufacturing cost may be reduced.

As described above, in the component for a home appliance of the present disclosure, the overall manufacturing cost may be reduced by increasing the amount of the second material or the third material, which is relatively cheaper than the first material.

In addition, in the component for a home appliance of the present disclosure, the first portion 210 and the second portion 220 may be formed by using the different injection gates 213 and 223, and thus injection molding may proceed quickly, thereby decreasing manufacturing time.

In addition, in the component for a home appliance of the present disclosure, the first portion 210 and the second portion 220 may be formed by using the different injection gates 213 and 223, and thus injection molding of large parts may also proceed smoothly.

In addition, in the component for a home appliance of the present disclosure, a portion that is visible with the naked eye may be constituted by the skin layer 211 and the core layer 212, and a portion that is difficult to see with the naked eye may be constituted only by the core layer 222, thereby achieving a sophisticated design and reducing a manufacturing cost.

Meanwhile, the component for a home appliance of the present disclosure may be implemented in a form other than the features or structures mentioned in the above-described embodiment.

In another form (a second form) of the component for a home appliance of the present disclosure, as illustrated in FIG. 17, the first portion 210 may be composed of only one skin layer 211 and one core layer 212.

For example, a front side (a front surface) that can be seen with the naked eye by the user may be formed as the skin layer 211, and a back side (a rear surface) that cannot be seen with the naked eye may be formed as the core layer 212.

Accordingly, the mixing amount of the core layer 212 may be further increased compared to a structure in which both the front surface and the rear surface of the component for a home appliance are formed as the skin layer 211, thereby further reducing the manufacturing cost.

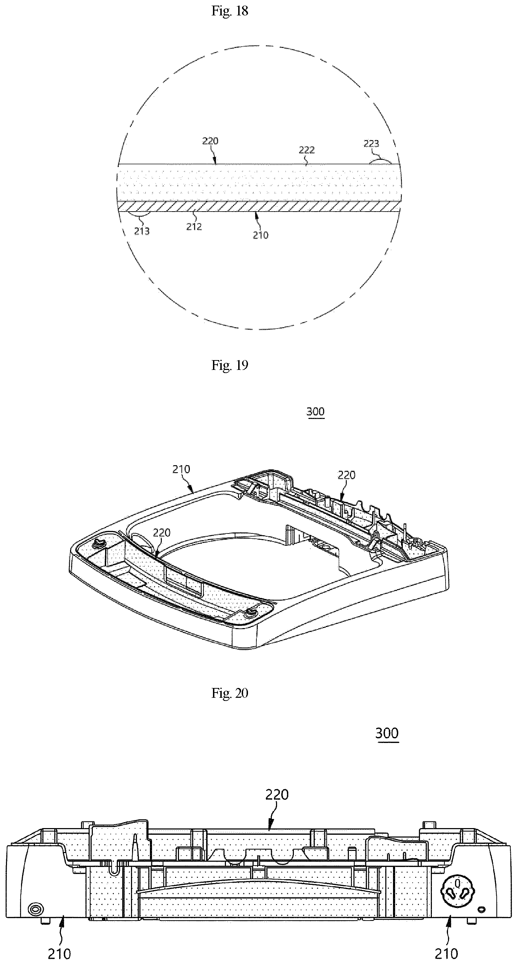

In another form (a third form) of the component for a home appliance of the present disclosure, as illustrated in FIG. 18, the first portion 210 may be composed of only one skin layer 211.

For example, when the front side (front surface) of the component for a home appliance is visible to a user with the naked eye, but the back side (rear surface) is not visible to the user with the naked eye, the front surface may be formed only as the skin layer 211 of the first portion 210, and the rear surface may be formed as the core layer 222 of the second portion 220.

Accordingly, the mixing amount of the third material may be further increased compared to a structure in which both the front and rear surfaces of the component for a home appliance are formed as the skin layer 211, thereby further reducing the manufacturing cost.

In another form (a fourth form) of the component for a home appliance of the present disclosure, the second material and the third material may be formed of different materials.

For example, the second material constituting the first portion 210 may be formed of a relatively inexpensive recycled resin, while the third material constituting the second portion 220 may be formed of a lightweight material.

As another example, the second material constituting the first portion 210 may be formed of a high-strength material (e.g., a GF-containing material), and the third material constituting the second portion 220 may be formed of a relatively inexpensive recycled resin.

As another example, the third material constituting the second portion 220 may include the second material of the first portion 210. For example, the third material may be formed by mixing a lighter material or a cheaper material with the second material.

As another example, the second material constituting the first portion 210 may include the third material of the second portion 220. For example, the second material may be formed by mixing a higher strength material or a more expensive material with the third material.

In another form (a fifth form) of the component for a home appliance of the present disclosure, the first portion 210 and the second portion 220 may be formed in different colors. That is, the second portion 220 may be provided in the same color as a raw material because the second portion 220 is provided in a location that is not visible to a user.

On the other hand, in another form of the component for a home appliance of the present disclosure, the first portion 210 and the second portion 220 may be formed in the same color. That is, the second portion 220 may be designed to appear as identical to the first portion 210 as possible, so that the second portion 220 may be applied even in a location that is not completely invisible to a user. Accordingly, the mixing amount of the third material for the second portion 220 may be further increased, thereby further reducing the manufacturing cost.

Meanwhile, FIGS. 19 to 25 provide another form (a sixth form) of the component for a home appliance of the present disclosure.

The sixth form of the present disclosure is an example of a case in which the component for a home appliance is a top frame 300 of a washing machine.

That is, when the component for a home appliance of the present disclosure is the top frame 300 of a washing machine, the second portion 220 may have a cover (not shown) coupled rotatably thereto and have a rear portion and a control panel (not shown) that are not visible to a user, and thus may be applied to at least one of front portions that are not visible to the user. The remaining portion visible to the user may be provided as the first portion 210.

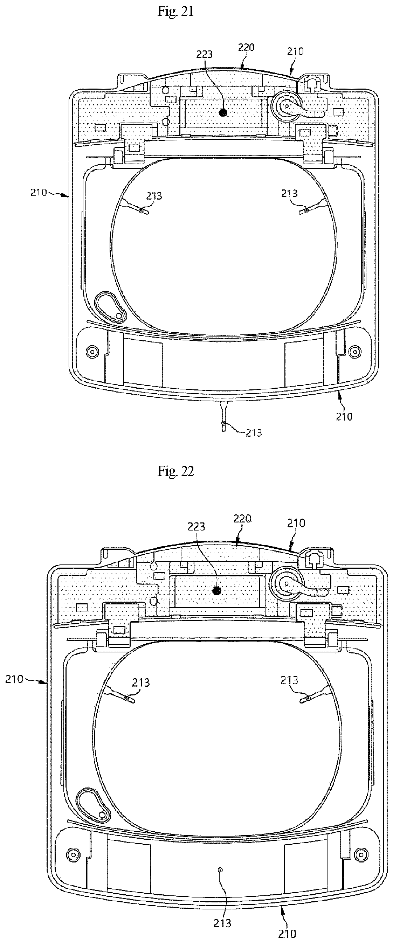

In addition, as another form (a seventh form) of the component for a home appliance of the present disclosure, as illustrated in FIGS. 21 to 25, the injection gates may be arranged in various ways depending on the structure of each portion of the component for a home appliance or the positions of the first portion 210 and the second portion 220.

For example, as illustrated in FIG. 21, a plurality of first injection gates 213 may be provided and only one second injection gate 223 may be provided.

As illustrated in FIG. 21, the first injection gates 213 may be located on the outer side of the first portion 210, and the second injection gate 223 may be located inside the second portion 220. That is, the first injection gates 213 may be cut and removed after the formation of the first portion 210. Of course, although not shown, the first injection gates 213 may be located inside the first portion 210, and the second injection gate 223 may be located on the outer side of the second portion 220.

As illustrated in FIG. 22, at least one of a plurality of first injection gates 213 may be positioned inside the first portion 210.

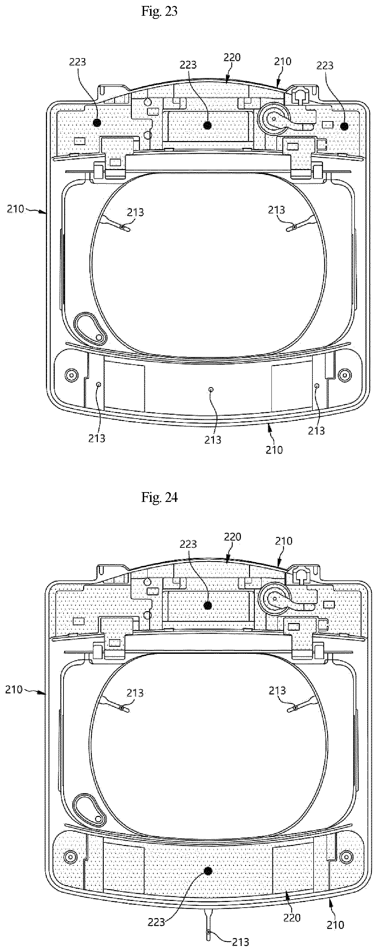

As illustrated in FIG. 23, a plurality of first injection gates 213 or second injection gates 223 may be provided and arranged so that the injection gates of the same type are positioned on the left and right.

As illustrated in FIG. 24, a first injection gate 213 and a second injection gate 223 may be arranged side by side in a front-to-rear direction. For example, when a plurality of second portions 220 are provided within the first portion 210, the first injection gate 213 and the second injection gate 223 may be positioned side by side in the front-to-rear direction.

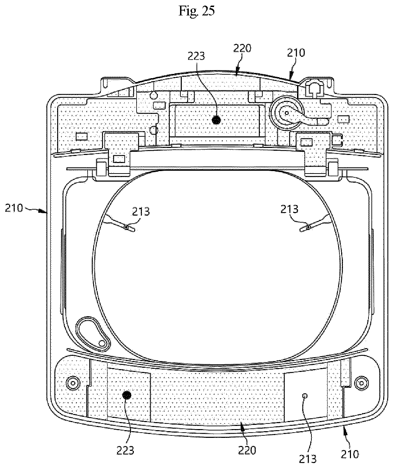

As illustrated in FIG. 25, the first injection gate 213 and the second injection gate 223 may be arranged side by side in a left-to-right direction. For example, when a plurality of second portions 220 are provided within the first portion 210, the first injection gate 213 and the second injection gate 223 may be positioned side by side in the left-to-right direction.

In this way, the component for a home appliance of the present disclosure may be transformed into various forms.

In the above, all the components according to the embodiments of the present disclosure are described as being coupled to each other as one or being operated in the coupled state, but the present disclosure is not necessarily limited to the embodiments. That is, if it is within the scope of the present disclosure, at least one of all of the components may be selectively combined and operated. In addition, the terms such as "include", "compose", or "have" as described above means that the corresponding components can be inherent unless specifically stated to the contrary. Accordingly, it should be interpreted that other components are not excluded, but may further be included. All terms, including technical or scientific terms, have the same meaning as generally understood by those skilled in the art to which the present disclosure belongs, unless otherwise defined. Commonly used terms, such as terms defined in a dictionary, should be interpreted as being consistent with the contextual meaning of the related art, and are not to be interpreted as ideal or excessively formal meanings unless explicitly defined in the present disclosure.

The above description is merely an illustrative description of the technical idea of the present disclosure, and those skilled in the art to which the present disclosure belongs may make various modifications and variations without departing from the essential characteristics of the present disclosure. Accordingly, the embodiments disclosed in the present disclosure are not intended to limit but describe the technical idea of the present disclosure, and the scope of the technical idea of the present disclosure is not limited by the embodiments. The scope of protection of the present disclosure should be interpreted in accordance with the claims below, and all technical ideas within the equivalent scope should be interpreted as being included in the scope of the claims of the present disclosure.

## Claims

1. A component for a home appliance, the component comprising:
a first portion that comprises a skin layer constituting an outer surface thereof and injection-molded with a first material, and a core layer located inside the skin layer and injection-molded with a second material; and
a second portion formed integrally with the first portion and having a core layer injection-molded with a third material.

2. The component of claim 1, wherein the first portion comprises a portion of the corresponding home appliance that is visible to a user.

3. The component of claim 1, or 2, wherein the second portion comprises a portion of the corresponding home appliance that is not visible to a user.

4. The component of claim 1, 2, or 3, wherein the second portion comprises a portion that is covered by another component for the home appliance.

5. The component of any one of claims 1 to 4, wherein the first portion and the second portion are provided with injection gates, respectively, through which each of the materials is supplied.

6. The component of any one of claims 1 to 5, wherein the first portion is provided with a first injection gate through which the first material and the second material are sequentially injected.

7. The component of claim 6, wherein the first injection gate comprises one first injection gate or at least two first injection gates.

8. The component of any one of claims 1 to 7, wherein the second portion provided with a second injection gate through which the third material is injected.

9. The component of claim 8, wherein the second injection gate comprises one second injection gate or at least two second injection gates.

10. The component of any one of claims 1 to 9, wherein a boundary between the first portion and the second portion is formed so that the first portion and the second portion are connected to each other in a vertical direction of the corresponding home appliance.

11. The component of any one of claims 1 to 10, wherein a boundary between the first portion and the second portion is formed so that the first portion and the second portion are connected to each other in a horizontal direction of the corresponding home appliance.

12. The component of any one of claims 1 to 11, wherein a boundary between the first portion and the second portion is formed so that a thickness of the skin layer constituting the first portion gradually decreases toward the second portion.

13. The component of any one of claims 1 to 12, wherein a boundary between the first portion and the second portion is formed so that a thickness of the core layer constituting the first portion gradually increases toward the second portion.

14. The component of any one of claims 1 to 13, wherein the second material and the third material are formed of the same materials.

15. The component of any one of claims 1 to 14, wherein the second material and the third material are formed of different materials.
